# EUROPÄISCHE PATENTSCHRIFT

(11) **EP 2 399 152 B1**
(45) Veröffentlichungstag und Bekanntmachung des Hinweises auf die Patenterteilung: **29.10.2014**
(21) Anmeldenummer: 10703834.1
(22) Anmeldetag: 03.02.2010
(51) Int. Cl.: G02B 6/42, H01L 31/05

(54) **VORRICHTUNG ZUR UMWANDLUNG VON LICHT IN EIN ELEKTRISCHES SIGNAL**
DEVICE FOR CONVERTING LIGHT INTO AN ELECTRIC SIGNAL
DISPOSITIF POUR CONVERTIR DE LA LUMIÈRE EN UN SIGNAL ÉLECTRIQUE

(30) Priorität: 18.02.2009 DE 202009002331 U
(43) Veröffentlichungstag der Anmeldung: 28.12.2011
(73) Patentinhaber: CCS Technology Inc., Wilmington, DE 19803 (US)
(72) Erfinder: KOSSAT, Rainer, 83229 Aschau (DE); HEIDLER, Christian, 82069 Hohenschäftlarn (DE); ZAMZOW, Bert, 82131 Stockdorf (DE)
(74) Vertreter: Epping - Hermann - Fischer
(86) Internationale Anmeldenummer: PCT/EP2010/051319
(87) Internationale Veröffentlichungsnummer: WO 2010/094568

(56) Entgegenhaltungen:
- EP-A2- 0 565 331
- US-A- 1 525 985
- US-A- 4 398 794
- US-A1- 2005 137 657

## Beschreibung

Die Erfindung betriff eine Vorrichtung zur Umwandlung von Licht, das durch ein optisches Übertragungselement übertragen wird, in ein elektrisches Signal.

Zur Übertragung von Daten werden in zunehmendem Maße optische Übertragungselemente, beispielsweise Lichtwellenleiter, eingesetzt. Eine Sendeeinheit wandelt die zu übertragenden Daten in Lichtimpulse um, die an einem Ende des optischen Übertragungselements in das Übertragungselement eingespeist werden. Die Lichtimpulse werden über das optische Übertragungselement zu einer Empfangseinheit, beispielsweise einer Videokamera, geführt und aus dem Lichtwellenleiter ausgekoppelt. Zur Energieversorgung der Empfangseinheit ist üblicherweise eine Versorgungsspannung erforderlich, die der Empfangseinheit über ein zusätzliches Kabel, beispielsweise ein Kupferkabel, zugeführt wird. Wenn man die Zuführung einer Energieversorgung durch ein separates Kabel vermeiden will, besteht die Möglichkeit, neben der Datenübertragung zu der Empfangseinheit auch die zum Betreiben der Empfangseinheit nötige Energie über das Lichtwellenleiterkabel zu übertragen. An der Empfangseinheit muss das Licht in ein elektrisches Signal umgewandelt werden, damit zum Betreiben der Empfangseinheit eine Versorgungsspannung bereitgestellt werden kann.

Die Druckschrift GB 1 525 985 zeigt eine Anordnung zum Auskoppeln einer Signalleistung aus einer optischen Lichtfaser. Die Lichtfaser weist einen gebogenen Abschnitt auf, aus dem Licht ausgekoppelt und von einem Fotodetektor empfangen wird. Die Druckschrift US 4,398,794 zeigt eine Koppeleinrichtung zum Auskoppeln von Licht aus einem Lichtwellenleiter. Der Lichtwellenleiter weist eine Biegung auf, an der Licht austritt und in ein Prisma eingekoppelt wird. An den Seitenwänden des Prismas wird das Licht reflektiert und trifft auf Fotodioden, die an einer Seite des Prismas angeordnet sind.

Die Druckschriften US 2005/0137657 A1 und EP 0565331 A2 zeigen optische Übertragungselemente in Form von Lichtfasern, die spiralförmig gebogen auf einem Körper angeordnet sind. Gemäß der Druckschrift US 2005/0137657 A1 wird aus den gebogenen Abschnitten des Lichtwellenleiters Licht emittiert und auf ein Objekt gerichtet. Gemäß der Druckschrift EP 0565331 A2 wird aus einer Lichtquelle ausgekoppeltes Licht in einen gebogenen Abschnitt des Lichtwellenleiters eingekoppelt.

Es ist wünschenswert eine Vorrichtung zur Umwandlung von Licht in ein elektrisches Signal anzugeben, mit der sich die Umwandlung von Licht in ein elektrisches Signal möglichst effizient gestaltet lässt.

Erfindungsgemäss wird diese Aufgabe gelöst durch eine Vorrichtung gemäss Anspruch 1 bzw. durch ein Verfahren gemäss Anspruch 10. Eine Ausführungsform einer derartigen Vorrichtung zur Umwandlung von Licht in ein elektrisches Signal ist im Anspruch 1 angegeben.

Die Vorrichtung zur Umwandlung von Licht in ein elektrisches Signal umfasst ein optisches Übertragungselement zur Übertragung von Licht und ein fotoelektrisches Sensorelement zur Umwandlung von Licht in ein elektrisches Signal. Das optische Übertragungselement weist einen spiralförmig gebogenen Abschnitt auf. Das optische Übertragungselement ist derart ausgebildet, dass in dem optischen Übertragungselement übertragenes Licht an dem gebogenen Abschnitt aus dem optischen Übertragungselement ausgekoppelt wird. Das fotoelektrische Sensorelement ist derart angeordnet, dass das aus dem optischen Übertragungselement ausgekoppelte Licht in das fotoelektrische Sensorelement eingekoppelt wird. Das fotoelektrische Sensorelement ist derart ausgebildet, dass das elektrische Signal beim Einkoppeln von Licht in das fotoelektrische Sensorelement erzeugt wird. Das optische Übertragungselement ist von dem fotoelektrischen Sensorelement umfänglich umgeben.

Mit der Vorrichtung zur Umwandlung von Licht in ein elektrisches Signal wird es ermöglicht, eine Energieversorgung über ein einziges Lichtwellenleiterkabel bereitzustellen. Bei einem Anschluss eines Lichtwellenleiters an die Vorrichtung zur Umwandlung von Licht in ein elektrisches Signal wird Licht, das in das optische Übertragungselement der Vorrichtung eingekoppelt worden ist, infolge der Biegung des optischen Übertragungselements an dem gebogenen Abschnitt ausgekoppelt und in das fotoelektrische Sensorelement eingekoppelt. In Abhängigkeit von einem Pegel des in das fotoelektrische Sensorelement eingekoppelten Lichts wird an den Anschlüssen des fotoelektrischen Sensorelements eine Spannung erzeugt, die beispielsweise als Versorgungsspannung zum Betreiben einer optischen Empfangseinheit, zum Beispiel zum Betreiben einer Videokamera, verwendet werden kann. Da das optische Übertragungselement in der Vorrichtung in einem großflächigen Bereich gebogen ist, wird das in das optische Übertragungselement der Vorrichtung eingekoppelte Licht über einen großen Flächenbereich verteilt ausgekoppelt. Das fotoelektrische Sensorelement kann eine große fotosensitive Fläche aufweisen, an der das Licht in das Sensorelement eingekoppelt wird. Durch das Einkoppeln des Lichts in einen großflächigen fotosensitiven Bereich des fotoelektrischen Sensorelements kann eine schnelle Erwärmung des fotoelektrischen Sensorelements verhindert werden. Somit wird die Effizienz bei der Umwandlung von Licht in ein elektrisches Signal erhöht.

Gemäß einer weiteren Ausführungsform der Vorrichtung können mehrere Lagen aus jeweils dem gebogenen Abschnitt des optischen Übertragungselements und dem fotoelektrischen Sensorelement übereinander angeordnet sein. Bei der Vorrichtung kann aus dem optischen Übertragungselement ausgekoppeltes Licht nach einer Modulation in das optische Übertragungselement eingekoppelt werden.

Gemäß einer anderen Ausführungsform der Vorrichtung weist das optische Übertragungselement einen weiteren Abschnitt auf, wobei der gebogene Abschnitt näher an dem fotoelektrischen Sensorelement als der weitere Abschnitt angeordnet ist. Das optische Übertragungselement ist derart ausgebildet, dass an dem gebogenen Abschnitt mehr Licht ausgekoppelt wird als an dem weiteren Abschnitt.

Gemäß einer anderen Ausführungsform der Vorrichtung ist das optische Übertragungselement auf einem Trägerelement angeordnet. Das Trägeelement kann zylinderförmig oder kegelförmig ausgebildet sein. Das Trägerelement kann einen Durchmesser zwischen 6 mm und 15 mm aufweisen. Das Trägerelement enthält beispielsweise ein Material aus Kunststoff, Metall oder Plexiglas. Das optische Übertragungselement kann in einem Schutzkörper eingebettet angeordnet sein. Das optische Übertragungselement ist beispielsweise in einem Material des Schutzkörpers eingegossen angeordnet oder von dem Material des Schutzkörpers umspritzt angeordnet. Das Material des Schutzkörpers kann transparent ausgebildet sein. Das optische Übertragungselement kann einen Lichtwellenleiter umfassen. Der Lichtwellenleiter kann einen inneren Bereich und einen äußeren Bereich aufweisen und zwischen dem inneren und äußeren Bereich kann eine Schicht von Nanostrukturen angeordnet sein. Gemäß einer weiteren Ausführungsform weist der Lichtwellenleiter einen inneren Bereich und einen äußeren Bereich auf und zwischen dem inneren und äußeren Bereich sind Hohlräume angeordnet, die ein Gas enthalten. Bei einer anderen Ausführungsform weist der Lichtwellenleiter einen inneren Bereich und einen äußeren Bereich auf und ein Material des inneren Bereichs und ein Material des äußeren Bereichs können jeweils unterschiedliche Brechungsindizes aufweisen. Der innere und äußere Bereich können ein Material aus Glas oder Kunststoff enthalten.

Gemäß einer weiteren Ausführungsform der Vorrichtung umfasst das fotoempfindliche Sensorelement einen Anschluss zum Bereitstellen einer Spannung. Das fotoelektrische Sensorelement ist derart ausgebildet, dass beim Einkoppeln von Licht in das fotoelektrische Sensorelement an dem Anschluss ein Pegel der Spannung in Abhängigkeit von einer Lichtstärke des eingekoppelten Lichts bereitgestellt wird. Das fotoelektrische Sensorelement kann umfänglich um das optische Übertragungselement angeordnet sein. Das fotoelektrische Sensorelement kann eine flexible Folie mit einem lichtempfindlichen Material umfassen. Das lichtempfindliche Material kann Silizium oder Galliumarsenid enthalten. Die Folie kann als eine kristalline Fotovoltaikfolie oder eine Dünnschicht-Fotovoltaikfolie ausgebildet sein. Das fotoelektrische Sensorelement kann mindestens ein fotoempfindliches Bauelement, insbesondere eine Fotodiode, umfassen, wobei das fotoempfindliche Bauelement auf einer Leiterplatte angeordnet ist. Die Leiterplatte kann mindestens ein lichtemittierendes Bauelement umfassen. Die Leiterplatte kann ein Bauelement zur Verarbeitung eines von dem mindestens einen fotoempfindlichen Bauelement beim Einkoppeln von Licht erzeugten Signals und zur Steuerung der lichtemittierenden Bauelemente umfassen. Das fotoempfindliche Sensorelement kann als eine äußere Ummantelung des Lichtwellenleiters ausgebildet sein.

Im Patentanspruch 10 wird ein Verfahren zur Umwandlung von Licht in ein elektrisches Signal angegeben. Gemäß dem Verfahren wird ein optisches Übertragungselement zur Übertragung von Licht und ein fotoelektrisches Sensorelement zur Umwandlung von Licht in ein elektrisches Signal bereit gestellt. Ein Abschnitt des optischen Übertragungselements wird spiralförmig gebogen. Das optische Übertragungselement wird mit dem fotoelektrischen Sensorelement umfänglich umgeben. In das optische Übertragungselement wird Licht eingekoppelt. Aus dem gebogenen Abschnitt des optischen Übertragungselements wird Licht ausgekoppelt. In das fotoelektrische Sensorelement wird Licht eingekoppelt. Durch das fotoelektrische Sensorelement wird das elektrische Signal erzeugt.

Gemäß einer weiteren Ausführungsform des Verfahrens ist das Bereitstellen des fotoelektrischen Sensorelements mit einem Anschluss zum Erzeugen einer Spannung vorgesehen. Beim Einkoppeln des Lichts in das fotoelektrische Sensorelement wird in Abhängigkeit von der Lichtstärke des eingekoppelten Lichts ein Pegel einer Spannung erzeugt.

Gemäß einer anderen Ausführungsform des Verfahrens kann der gebogene Abschnitt des optischen Übertragungselements auf einem Trägerelement angeordnet werden. Der gebogene Abschnitt des optischen Übertragungselements kann in ein Material eingebettet werden.

Gemäß einer weiteren Ausführungsform des Verfahrens kann das fotoelektrische Sensorelement um den gebogenen Abschnitt des optischen Übertragungselements umfänglich angeordnet werden. Des weiteren kann eine Lage aus weiteren gebogenen Abschnitten eines weiteren optischen Übertragungselements und eines weiteren fotoelektrischen Sensorelements um das fotoelektrische Sensorelement angeordnet werden.

Bei einer weiteren Ausführungsform des Verfahrens ist das Bereitstellen des optischen Übertragungselements, das als ein Lichtwellenleiter ausgebildet ist, wobei der Lichtwellenleiter einen inneren Bereich und einen um den inneren Bereich angeordneten äußeren Bereich aufweist, vorgesehen. zur Übertragung von Daten wird Licht in den inneren Bereich des Lichtwellenleiters eingekoppelt. Licht, das zur Umwandlung in das elektrische Signal vorgesehen ist, wird in den äußeren Bereich des Lichtwellenleiters eingekoppelt. Das Licht, das zur Übertragung von Daten dient, kann in den Lichtwellenleiter an einer Stirnfläche des inneren Bereichs des Lichtwellenleiters eingekoppelt werden. Licht, das zur Umwandlung in das elektrische Signal dient, kann durch ein tangentiales Bestrahlen des gebogenen Abschnitts des Lichtwellenleiters mit dem Licht in den Lichtwellenleiter eingekoppelt werden.

Gemäß einer weiteren Ausführungsform des Verfahren kann das Licht zur Übertragung von Daten aus dem Lichtwellenleiter ausgekoppelt werden. Das ausgekoppelte Licht kann moduliert werden. Das modulierte Licht wird in den Lichtwellenleiter eingekoppelt.

Die Erfindung wird im Folgenden anhand von Figuren, die Ausführungsbeispiele der vorliegenden Erfindung zeigen, näher erläutert.

Es zeigen:
- Figur 1: eine Ausführungsform einer Vorrichtung zur Umwandlung von Licht in ein elektrisches Signal,
- Figur 2A: eine weitere Ausführungsform einer Vorrichtung zur Umwandlung von Licht in ein elektrisches Signal in perspektivischer Ansicht,
- Figur 2B: eine Queransicht der weiteren Ausführungsform einer Vorrichtung zur Umwandlung von Licht in ein elektrisches Signal,
- Figur 3A: eine weitere Ausführungsform einer Vorrichtung zur Umwandlung von Licht in ein elektrisches Signal,
- Figur 3B: ein Vergleichsbeispiel einer Vorrichtung zur Umwandlung von Licht in ein elektrisches Signal,
- Figur 4: ein Vergleichsbeispiel eines optischen Übertragungselements zum Auskoppeln von Licht,
- Figur 5: ein Beispiel eines fotoelektrischen Sensorelements zur Umwandlung von Licht in ein elektrisches Signal,
- Figur 6: ein optisches Übertragungselement zur Führung von Licht zur Übertragung von Daten und zur Bereitstellung einer Energieversorgung,
- Figur 7: eine Vorrichtung zum Einkoppeln von Licht in ein optisches Übertragungselement,
- Figur 8: eine Ausführungsform einer Vorrichtung zum Auskoppeln von Licht aus einem optischen Übertragungselement.

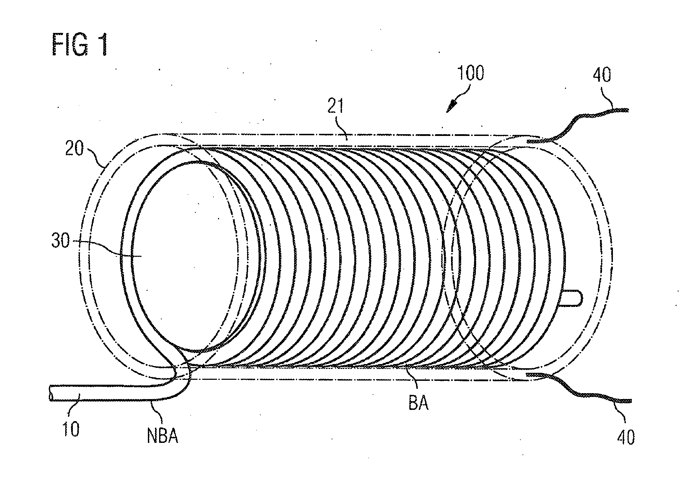

Figur 1 zeigt eine Ausführungsform einer Vorrichtung 100 zur Umwandlung von Licht in ein elektrisches Signal. Die Vorrichtung umfasst ein optisches Übertragungselement 10, beispielsweise einen Lichtwellenleiter. Das optische Übertragungselement weist mehrere Biegungen auf. Bei der in Figur 1 gezeigten Ausführungsform ist das optische Übertragungselement 10 beispielsweise spiralförmig in mehreren Windungen gebogen.

Das optische Übertragungselement ist von einem fotoelektrischen Sensorelement 20 umgeben. Das fotoelektrische Sensorelement ist derart ausgebildet, dass bei Einkoppeln von Licht von dem fotoelektrischen Sensorelement ein elektrisches Signal erzeugt wird. Das elektrische Signal kann eine Spannung sein. Zum Bereitstellen des elektrischen Signal, beispielsweise einer elektrischen Spannung, weist das fotoelektrische Sensorelement Anschlüsse 40 auf.

Zum Betreiben der Vorrichtung wird Licht in den Lichtwellenleiter 10 eingekoppelt. Das Licht wird zunächst in einem ungebogenen Abschnitt NBA des optischen Übertragungselements in dem optischen Übertragungselement geführt. An denjenigen Stellen, an denen das optische Übertragungselement eine Biegung aufweist, tritt ein Teil des Lichts aus dem optischen Übertragungselement aus. Der Anteil des Lichts, das aus dem optischen Übertragungselement ausgekoppelt wird, ist insbesondere von dem Biegeradius abhängig, mit dem das optische Übertragungselement gebogen ist. Das optische Übertragungselement kann in einem Biegeradius zwischen 3 mm bis 10 mm gebogen sein. Je enger der Biegeradius gewählt wird, desto höher ist der Anteil des Lichts, das an dem gebogenen Abschnitt aus dem optischen Übertragungselement austritt. Bei der in Figur 1 gezeigten Ausführungsform kann das optische Übertragungselement in Windungen gebogen sein, die einen Durchmesser zwischen beispielsweise 6 mm und 15 mm aufweisen.

Durch die Biegung des Lichtwellenleiters in dem Abschnitt BA wird an jeder Windung ein Teil des Licht aus dem optischen Übertragungselement ausgekoppelt. Da der Biegeradius beziehungsweise der Durchmesser der Windungen über die gesamte Länge des gebogenen Abschnitts gleichmäßig ist, wird in jeder Windung ein gleicher Anteil des in den optischen Übertragungselement übertragenen Lichts ausgekoppelt. Das ausgekoppelte Licht trifft auf den fotoelektrischen Sensor 20, der das optische Übertragungselement 10 in dem gebogenen Abschnitt BA umgibt. Beim Einkoppeln des Lichts in das fotoelektrische Sensorelement 20 wird an den Anschlüssen 40 ein elektrisches Signal erzeugt.

Damit das Licht in dem gebogenen Abschnitt BA möglichst verlustfrei aus dem optischen Übertragungselement 10 austritt, kann das optische Übertragungselement eine Ummantelung (Coating) mit geringer Absorption aufweisen. Dadurch wird gewährleistet, dass beim Auskoppeln des Lichts aus dem optischen Übertragungselement 10 möglichst wenig Energie in Wärme umgewandelt wird. Die Absorption des Coatings sollte insbesondere in einem Wellenlängenbereich zwischen 800 nm und 850 nm, der beispielsweise zur Übertragung des Lichts in den Lichtwellenleiter 10 vorgesehen ist, gering sein. Das optische Übertragungselement kann derart ausgebildet sein, dass die Absorption des Lichts insbesondere in dem gebogenen Abschnitt des optischen Übertragungselement, der nahe an den fotoelektrischen Sensorelement 20 angeordnet ist, geringer ist als an dem Abschnitt NBA, der keine Biegung aufweist oder weiter von dem fotoelektrischen Sensorelement entfernt ist.

Besonders geringe Verluste treten bei Verwendung eines optischen Übertragungselements mit einer transparenten Ummantelung auf. Die Ummantelung sollte insbesondere in dem Wellenlängenbereich, der zur Übertragung des Lichts in dem optischen Übertragungselement vorgesehen ist, transparent sein. Beispielsweise kann das optische Übertragungselement derart ausgestaltet sein, dass das optische Übertragungselement beispielsweise für Licht mit einer Wellenlänge zwischen 800 nm und 850 nm transparent ist.

Um Verluste, die nach dem Auskoppeln des Lichts aus dem optischen Übertragungselement 10 und vor dem Einkoppeln des Lichts in das fotoelektrische Sensorelement 20 entstehen, möglichst gering zu halten, ist das fotoelektrische Sensorelement möglichst nahe an dem gebogenen Abschnitt BA des optischen Übertragungselements 10 angeordnet. Das fotoelektrische Sensorelement 20 kann beispielsweise im Bereich des gebogenen Abschnitts BA an dem Material des optischen Übertragungselementes 10 anliegen oder von dem optischen Übertragungselement 10 eine Abstand zwischen 0,5 mm und 3 mm aufweisen.

Das fotoelektrische Sensorelement 20 kann als eine flexible Folie ausgebildet sein. Beispielsweise lässt sich zur Energieumwandlung eine kristalline Fotovoltaikfolie oder eine Dünnschicht-Fotovoltaikfolie einsetzen. Zur effizienten Erzeugung von elektrischer Energie weist das fotoelektrische Sensorelement 20 ein Material aus Silizium oder Galliumarsenid auf. Wenn das optische Übertragungselement ein Lichtwellenleiter ist, kann das fotoelektrische Sensorelement 20 gemäß einer weiteren möglichen Ausführungsform als eine Ummantelung eines Lichtwellenleiters 10 ausgebildet sein. Bei dieser Ausführungsform ist der lichtleitende Teil des optischen Übertragungselements 10 von einem Coating umgeben, das einen fotoelektrischen Effekt aufweist. Dadurch wird das infolge der Biegung aus dem lichtführenden Teil des Lichtwellenleiters 10 ausgekoppelte Licht unmittelbar in die Ummantelung eingekoppelt. Aufgrund des fotovoltaischen Effekts wird die Energie des eingekoppelten Lichts in dem fotoelektrischen Sensorelement in ein elektrisches Signal gewandelt. An einer Oberfläche der Ummantelung des Lichtwellenleiters 10 kann somit beispielsweise eine elektrische Spannung abgegriffen werden.

Das optische Übertragungselement 10 kann ein Lichtwellenleiter sein, der mit einer Ummantelung (Coating) oder ohne Ummantelung ausgeführt ist. Wenn der Lichtwellenleiter 10 von einer Ummantelung umgeben ist, kann er beispielsweise einen Durchmesser von 250 µm aufweisen. Wenn ein Lichtwellenleiter ohne Ummantelung verwendet wird, kann der Außendurchmesser beispielsweise 125 µm betragen. Als Materialien für das optische Übertragungselement 10 lassen sich Glasfasern oder Kunststofffasern verwenden. Bei Verwendung einer Kunststofffaser (pof-Faser: Plastic Optical Fiber) kann der Außendurchmesser des Lichtwellenleiters ungefähr 1 mm betragen.

Zur Stützung der gebogenen Anordnung des optischen Übertragungselements kann ein Trägerelement 30 vorgesehen sein, um das das optische Übertragungselement 10 spiralförmig in mehreren Windungen angeordnet ist. Das Trägerelement 30 kann beispielsweise zylinderförmig ausgestaltet sein. Als Materialien für das Trägerelement können transparente Materialien, wie beispielsweise Plexiglas, verwendet werden. Das Trägerelement kann auch aus einem Metall oder Kunststoff gefertigt sein. Der Durchmesser des Trägerelements beziehungsweise der Durchmesser der spiralförmigen Anordnung des optischen Übertragungselements 10 wird in Abhängigkeit von der Biegeempfindlichkeit des optischen Übertragungselements 10 gewählt.

Unter Biegeempfindlichkeit ist die Fähigkeit des optischen Übertragungselements zu verstehen, an einer Biegung in Abhängigkeit von einem Biegeradius einen Anteil des in dem optischen Übertragungselement geführten Lichts auszukoppeln. Je höher die Biegeempfindlichkeit des optischen Übertragungselements ist, desto höher ist der Anteil des Lichts, das bei einem bestimmten Biegeradius beziehungsweise bei einem bestimmten Durchmesser einer gebogenen Windung des optischen Übertragungselements ausgekoppelt werden kann. Das optische Übertragungselement kann in einem Biegeradius zwischen 3 mm und 10 mm angeordnet sein. Der Durchmesser des Trägerelements kann beispielsweise zwischen 6 mm und 15 mm betragen.

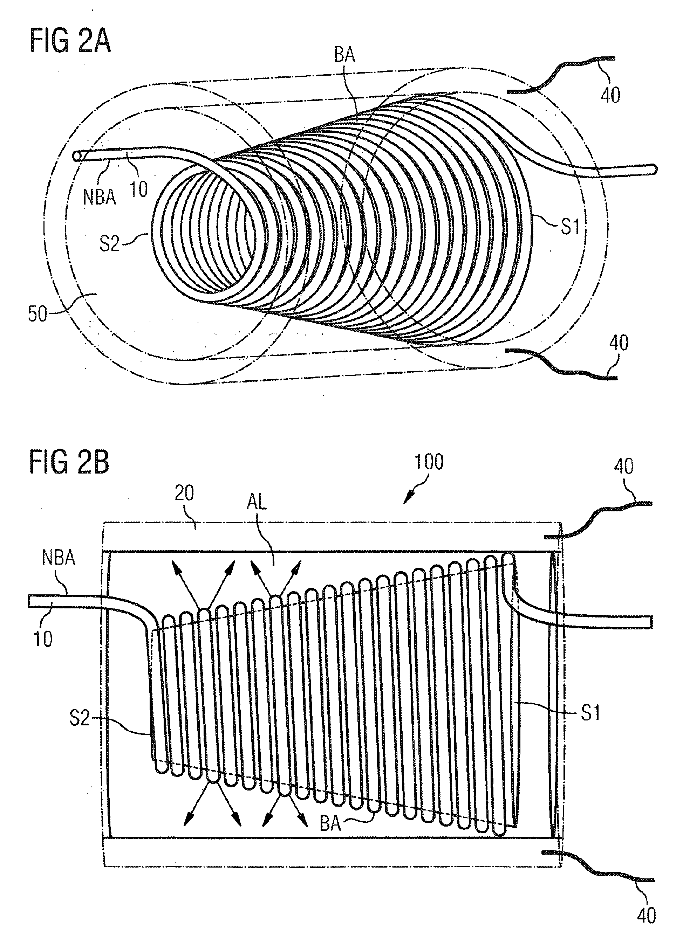

Figur 2A zeigt eine perspektivische Ansicht und Figur 2B zeigt eine Queransicht einer weiteren Ausführungsform einer Vorrichtung zur Umwandlung von Licht in ein elektrisches Signal. Bei der in den Figuren 2A und 2B gezeigten Ausführungsform werden für gleiche Elemente die gleichen Bezugszeichen wie in Figur 1 verwendet. Bei der in den Figuren 2A und 2B gezeigten Ausführungsform ist ein optisches Übertragungselement 10 in einem Abschnitt BA kegelförmig gebogen.:Dabei verjüngt sich der Durchmesser der Windungen des optischen Übertragungselements 10 von einer Seite S1 zu einer gegenüberliegend angeordneten Seite S2 der Vorrichtung. Das optische Übertragungselement 10 ist auch bei der in den Figuren 2A und 2B gezeigten Ausführungsform von dem fotoelektrischen Sensorelement 20 umfänglich umgeben.

Wenn Licht in dem optischen Übertragungselement 10 geführt wird, entsteht an dem gebogenen Abschnitt BA ein Lichtaustritt AL. Das optische Übertragungselement kann derart ausgebildet sein, dass Licht mit einer numerischen Apertur von 10° entlang des gebogenen Abschnitts BA des optischen Übertragungselements aus dem Material des Übertragungselements 10 austreten. Das aus dem optischen Übertragungselement 10 ausgekoppelte Licht wird auf eine Oberfläche des fotoelektrischen Sensorelements 20 gestreut. Nach dem Einkoppeln des gestreuten Lichts in das fotoelektrische Sensorelement 20 wird an den Anschlüssen 40 eine elektrische Spannung erzeugt. Der Pegel der erzeugten Spannung ist abhängig von der Lichtleistung, mit der das ausgekoppelte Licht auf die Oberfläche des fotoelektrischen Sensorelements auftrifft.

Bei der in den Figuren 2A und 2B gezeigten Ausführungsform kann das optische Übertragungselement 10 als ein Lichtwellenleiter ausgeführt sein, der eine Ummantelung (Coating) mit geringer Absorption aufweist. Die Ummantelung sollte insbesondere im Wellenlängenbereich des übertragenen Lichts, beispielsweise in einem Wellenbereich zwischen 800 nm und 850 nm eine möglichst geringe Absorption aufweisen. Insbesondere kann der Lichtwellenleiter derart ausgebildet sein, dass die Ummantelung in dem Bereich des gebogenen Abschnitts BA, der nahe an dem fotoelektrischen Sensorelement 20 angeordnet ist, eine geringere Absorption aufweisen als an einem geraden Abschnitt NBA des optischen Übertragungselements, der weiter von dem fotoelektrischen Sensorelement entfernt ist. Um Verluste bei der Auskopplung von Licht aus dem optischen Übertragungselement sehr gering zu halten, kann beispielsweise ein Lichtwellenleiter mit einer transparenten Ummantelung verwendet werden. Die Ummantelung kann insbesondere für Licht mit einer Wellenlänge zwischen 800 nm und 850 nm transparent sein.

Um die Umwandlung von Lichtenergie in Wärmeenergie zu begrenzen, kann ein Lichtwellenleiter verwendet werden, der in dem kegelförmig gebogenen Abschnitt BA keine Ummantelung aufweist. Der Außendurchmesser eines Lichtwellenleiters mit Ummantelung kann bis zu 250 µm betragen. Der Außendurchmesser eines Lichtwellenleiters ohne Ummantelung kann beispielsweise 125 µm betragen. Es können Lichtwellenleiter mit Glasfasern oder Kunststofffasern verwendet werden. Ein Lichtwellenleiter mit Kunststofffasern kann einen Außendurchmesser von bis zu 1 mm Durchmesser aufweisen.

Als fotoelektrisches Sensorelement 20 kann beispielsweise eine flexible Folie verwendet werden, mit der es ermöglicht wird, den kegelförmig gebogenen Abschnitt des Lichtwellenleiters 10 umfänglich zu umgeben. Beispielsweise kann eine kristalline Fotovoltaikfolie oder eine Dünnschicht-Fotovoltaikfolie verwendet werden. Zur Umwandlung von Licht in ein elektrisches Signal weist das fotoelektrische Sensorelement ein Material aus Silizium oder Galliumarsenid auf.

Bei der in den Figuren 2A und 2B gezeigten Ausführungsform der Vorrichtung zur Umwandlung von Licht in ein elektrisches Signal kann das optische Übertragungselement 10 an einem Trägerelement, wie beispielsweise dem in Figur 1 gezeigten Trägerelement 30, angeordnet sein. Im Unterschied zu der in Figur 1 gezeigten Ausführungsform ist das Trägerelement bei der in den Figuren 2A und 2B gezeigten Ausführungsform nicht zylinderförmig, sondern kegelförmig ausgebildet. Durch die kegelförmige Biegung des optischen Übertragungselements 10 wird es ermöglicht, über den gesamten Bereich des gebogenen Abschnitts BA Licht gleichmäßig verteilt auszukoppeln. Da der Biegeradius des optischen Übertragungselements von der Seite S1 zur Seite S2 abnimmt und somit an der Seite S2 ein höherer Anteil des Lichts ausgekoppelt wird, kann die über die gesamte Länge des Kegels durch den Lichtaustritt abnehmende Lichtleistung kompensiert werden, wenn Licht von der Seite S1 zur Seite S2 übertragen wird. Dadurch ist eine gleichmäßige Verteilung der Lichtleistung über den gesamten gebogenen Abschnitt BA gewährleistet.

Es ist bei den in den Figuren 1, 2A und 2B gezeigten Ausführungsformen der Vorrichtung zur Umwandlung von Licht in ein elektrisches Signal möglich, das optische Übertragungselement 10 in einen Schutzkörper 50 einzubetten. Der Schutzkörper 50 kann ein transparentes Material, beispielsweise ein transparentes Material aus einem Kunststoff, enthalten. Das optische Übertragungselement 10 kann in das Material des Schutzkörpers eingegossen sein. Bei einer anderen Ausführungsform ist das Material des Schutzkörpers um das optische Übertragungselement 10 gespritzt angeordnet.

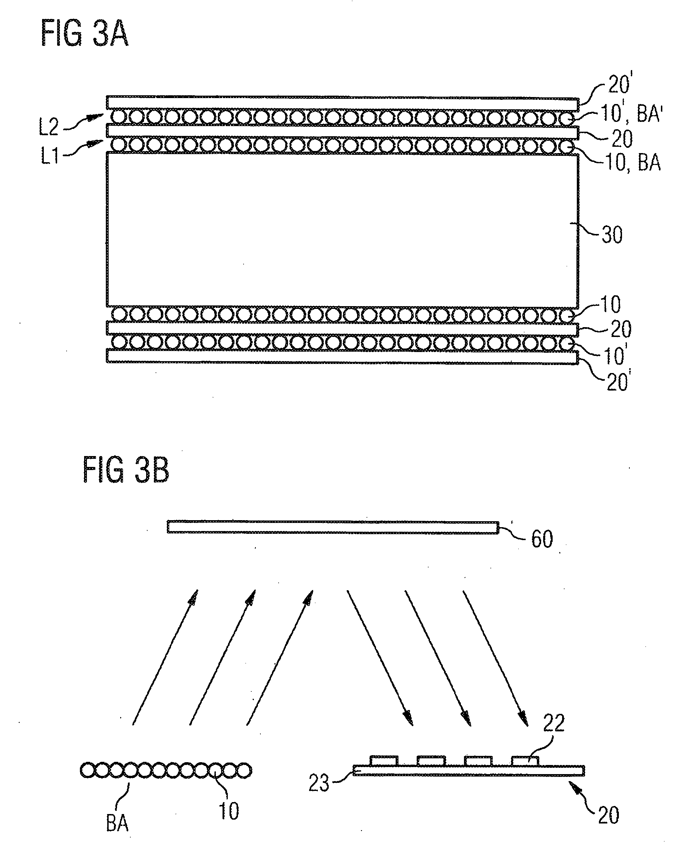

Die Figur 3A zeigt einen Querschnitt einer Ausführungsform einer Vorrichtung zur Umwandlung von Licht in ein elektrisches Signal, bei der mehrere Lagen L1, L2 aus jeweils einem gebogenen Abschnitt eines optischen Übertragungselements und einen fotoelektrischen Sensorelements übereinander angeordnet sind. Bei der in Figur 3A gezeigten Ausführungsform umfasst eine Lage L1 einen gebogenen Abschnitt BA des Lichtwellenleiters 10, um den das fotoelektrische Sensorelement 20 angeordnet ist. Eine Lage L2 umfasst einen gebogenen Abschnitt BA' eines weiteren optischen Übertragungselements 10', um den ein weiteres fotoelektrisches Sensorelement 20' angeordnet ist. Die optischen Übertragungselemente 10 und 10' sind jeweils spiralförmig um ein Trägerelement 30 angeordnet. Bei Verwendung einer flexiblen Folie als fotoelektrisches Sensorelement lassen sich die Sensorelemente 20 und 20' um die gebogenen Abschnitte BA beziehungsweise BA' des optischen Übertragungselements 10, 10' umfänglich anordnen.

Durch die Schichtanordnung wird die Effizienz der Umwandlung des aus den gebogenen Abschnitten der optischen Übertragungs-. elemente 10 und 10' ausgekoppelten Lichts in ein elektrisches Signal erhöht. Die Lagen L1 und L2 können zur Verbesserung der Stabilität um ein zentral angeordnetes Trägerelement 30 angeordnet sein oder von einem transparentes Material, beispielsweise von einem transparenten Kunststoff umgeben sein. Die Lagen L1 und L2 können bei letzterer Ausführungsform in das Material eingegossen oder von dem Material umspritzt sein. Bei einer solchen Ausführungsform kann der Trägerkörper 30 entfallen.

Figur 3B zeigt ein Vergleichsbeispiel der Vorrichtung zur Umwandlung von Licht in ein elektrisches Signal in einer Querschnittansicht. Das optische Übertragungselement 10 weist in dem Abschnitt BA Biegungen auf. Bei kleinem Biegeradius, beispielsweise einem Biegeradius von 3 mm bis 10 mm, wird Licht, das in dem optischen Übertragungselement 10 übertragen wird, an den gebogenen Bereichen BA des optischen Übertragungselements ausgekoppelt. Das ausgekoppelte Licht fällt auf einen Reflektor 60 und wird von dort auf ein fotoelektrisches Sensorelement 20 reflektiert. Das fotoelektrische Sensorelement 20 kann eine Fotovoltaikfolie sein. Es können auch Fotoelemente 22 vorgesehen sein, die beim Einkoppeln von Licht die zugeführte Lichtenergie in ein elektrisches Signal, beispielsweise eine elektrische Spannung, umwandeln. Dadurch wird von den fotoempfindlichen Bauelementen 22 eine Spannung bereitgestellt. Die fotoempfindlichen Bauelemente 22 können auf einem Trägermaterial 23 angeordnet sein. Das Trägermaterial 23 kann ein starres Material, beispielsweise eine Leiterplatine, sein.

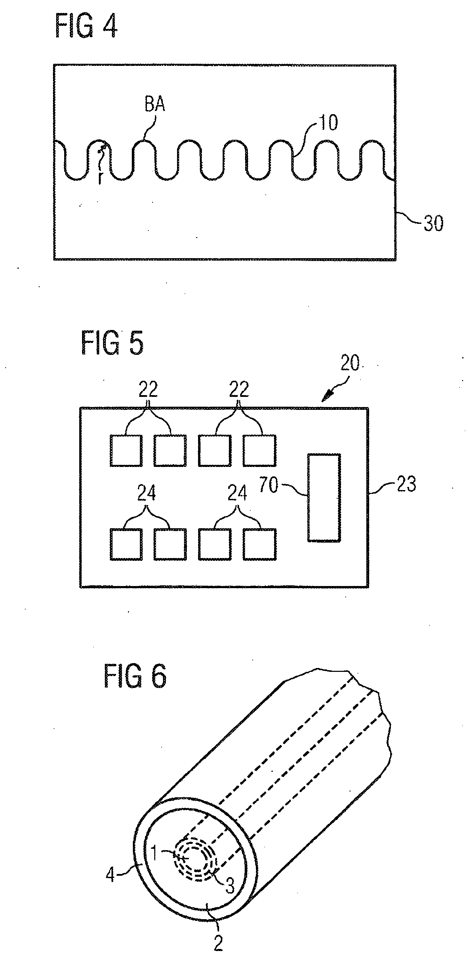

Figur 4 zeigt ein Vergleichsbeispiel eines optischen Übertragungselementes 10, das gebogene Abschnitte BA aufweist. Das optische Übertragungselement 10 kann beispielsweise eine optische Leiterbahn sein, die auf einem Trägerelement 30 angeordnet ist. Die Leiterbahn kann ein Material aus Glas oder Kunststoff enthalten, das auf dem Trägerkörper 30 aufgebracht ist. Die Biegungen BA können einen Biegeradius r zwischen 3 mm bis 10 mm aufweisen. An den gebogenen Abschnitten BA wird Licht, das in die Lichtwellenleiterführung 10 eingespeist worden ist, ausgekoppelt.

Bei dem in Figur 4 dargestellten Beispiel ist die Lichtwellenleiterführung 10 in einer Ebene angeordnet. Ein fotoelektrisches Sensorelement kann über der Ebene der Lichtwellenleiterführung 10 angeordnet sein. Das fotoelektrische Sensorelement kann auch in der gleichen Ebene wie die Lichtwellenleiterführung 10 angeordnet sein, wenn beispielsweise ein Reflektorelement über der Ebene, in der sich die Lichtwellenleiterführung 10 befindet, angeordnet ist. Somit kann an den gebogenen Abschnitten BA ausgekoppeltes Licht nach einer Reflexion an dem Reflektorelement in ein fotoelektrisches Sensorelement eingekoppelt werden.

Figur 5 zeigt ein Beispiel des fotoelektrischen Sensorelements 20, bei dem mehrere fotoempfindliche Bauelemente 22 auf einer Trägerplatine 23 angeordnet sind. Die Trägerplatine 23 kann beispielsweise eine flexible Leiterplatte sein. Auf der Trägerplatine können weitere Bauelemente 70 zur Verarbeitung der von den fotoempfindlichen Bauelementen beim Einkoppeln von Licht erzeugten Spannung angeordnet sein. Derartige Bauelemente können beispielsweise Spannungsübertrager sein. Des Weiteren können die Bauelemente 70 Steuerbauelemente zur Steuerung der fotoempfindlichen Bauelemente 22 sein. Beispielsweise können auf der Trägerplatine 23 Filter zum wellenlängenselektiven Empfang von Licht platziert sein. Auf der Trägerplatine können auch beispielsweise optische Sendebauelemente 24, wie zum Beispiel Laserdioden, angeordnet sein. Die Steuerung der optischen Sendebauelemente kann von den Steuerbauelementen 70 übernommen werden. Die von den optischen Sendebauelementen erzeugten Lichtsignale werden an gebogenen Abschnitten eines optischen Übertragungselementes wieder in das optische Übertragungselement eingekoppelt.

Bei den in den Figuren 1 bis 4 gezeigten Anordnungen kann das optische Übertragungselement ein Lichtwellenleiter, beispielsweise eine Lichtwellenleiterfaser, sein. Die Lichtwellenleiterfaser weist einen lichtführenden Kern, aus einem Material aus Glas oder Kunststoff auf, der von einer schützenden Ummantelung (Coating) umgeben ist.

In Figur 6 ist eine weitere Ausführungsform eines optischen Übertragungselements gezeigt, die bei den in den Figuren 1 bis 4 gezeigten. Vorrichtungen zur Umwandlung von Licht in ein elektrisches Signal eingesetzt werden kann. Bei der in Figur 6 gezeigten Ausführungsform ist das optische Übertragungselement als ein Hybrid-Lichtwellenleiter ausgeführt. Der Hybrid-Lichtwellenleiter kann zur Übertragung von Daten und zur Übertragung einer Energieversorgung verwendet werden. Der Lichtwellenleiter 10 weist einen inneren Bereich 1 auf, der zur Übertragung von Daten vorgesehen ist. Der innere Bereich ist von einem äußeren Bereich 2 umgeben, der zur Übertragung von Licht vorgesehen ist, das aus dem Lichtwellenleiter 10 zum Bereitstellen einer Energieversorgung an einem gebogenen Abschnitt des Lichtwellenleiters ausgekoppelt werden kann. Die Bereiche 1 und 2 können aus dem gleichen Material, beispielsweise aus Glas oder Kunststoff, hergestellt sein.

Damit sich die Lichtführung des Lichts in dem inneren Bereich 1 und dem äußeren Bereich 2 nicht gegenseitig beeinflusst, kann das Material des inneren und äußeren Bereichs des Lichtwellenleiters einen unterschiedlichen Brechungsindex aufweisen. Bei einer weiteren Ausführungsform des Lichtwellenleiters sind um den inneren Bereich 1 Nanostrukturen 3 angeordnet. Die Nanostrukturen 3 können beispielsweise Luftlöcher sein, die entlang des Lichtwellenleiters zwischen dem inneren Bereich 1 und dem äußeren Bereich 2 röhrenförmig ausgebildet sind. In den röhrenförmigen Hohlräumen kann ein Gas, beispielsweise Luft, enthalten sein. Die Nanostrukturen verhindern, dass Licht, das in dem Kernbereich 1 geführt wird, in den äußeren Bereich 2 austreten kann, und umgekehrt, dass Licht; das in dem äußeren Materialbereich 2 geführt wird, in den inneren Bereich 1 eindringen kann. Der Lichtwellenleiter 10 kann von einer Ummantelung (Coating) 4 umgeben sein. Die Ummantelung ist zum Auskoppeln von Licht, das in dem äußeren Bereich 2 übertragen wird, in dem Wellenlängenbereich des übertragenen Lichtes transparent oder weist eine geringe Absorption auf. Um ein möglichst verlustfreies Auskoppeln von Licht aus dem äußeren Bereich 2 an gebogenen Abschnitten des Lichtwellenleiters zu ermöglichen, kann das Coating an den gebogenen Abschnitten entfernt sein.

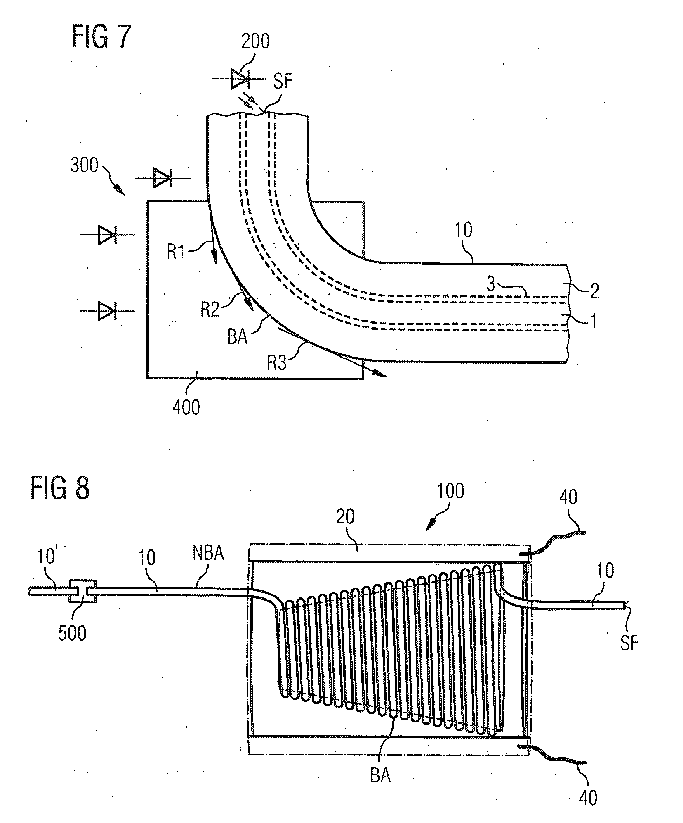

Figur 7 zeigt die Einkopplung von Licht an einem gebogenen Abschnitt BA eines optischen Übertragungselements 10. Das optische Übertragungselement kann ein Lichtwellenleiter sein, der in der in Figur 6 gezeigten Ausführungsform ausgebildet ist. Eine Sendeeinheit 200, die beispielsweise eine Laserdiode umfassen kann, koppelt Licht an einer Stirnfläche SF des optischen Übertragungselements 10 in den inneren Bereich 1 des Lichtwellenleiters ein. Wie bei der in Figur 6 gezeigten Ausführungsform ist der innere Bereich 1 des Lichtwellenleiters von einer Schicht von Nanostrukturen 3 umgeben. Dadurch wird gewährleistet, dass an dem gebogenen Abschnitt BA das Licht in dem inneren Bereich 1 weitergeführt wird.

Zum Einkoppeln von Licht in den äußeren Bereich 2 ist eine Sendeeinheit 300 vorgesehen. Die Sendeeinheit 300 kann beispielsweise eine Vielzahl von Laserdioden umfassen, die Licht in tangentialer Richtung auf den gebogenen Abschnitt BA des Lichtwellenleiters 10 strahlen. Der gebogene Abschnitt BA des Lichtwellenleiters 10 ist von einem Koppelelement 400 umgeben, das zum Einkoppeln von Licht in den Lichtwellenleiter vorgesehen ist. Das Koppelelement 400 ist aus einem Material ausgebildet, das für das von den Laserdioden 300 erzeugte Licht transparent ist und den gleichen Brechungsindex wie das Material des optischen Übertragungselementes 10 aufweist. Die Sendeeinheiten 300 sind in der Weise angeordnet, dass das von ihnen erzeugte Licht tangential auf Randbereiche R1, R2 und R3 des äußeren Bereich 2 fällt. Durch das Material des Koppelelements 400 und die Anordnung der Sendeeinheiten 300 wird sichergestellt, dass das aus den Laserdioden 300 ausgekoppelte Licht an dem gebogenen Abschnitt BA in den äußeren Bereich 2 des optischen Übertragungselementes 10 eingekoppelt wird.

Figur 8 zeigt die Ankopplung eines optischen Übertragungselements an eine Vorrichtung 100 zur Umwandlung von Licht in ein elektrisches Signal sowie das Auskoppeln von Licht aus einem optischen Übertragungselement. Das optische Übertragungselement 10' weist beispielsweise die in Figur 6 gezeigte Ausführung eines Lichtwellenleiters auf. Der Lichtwellenleiter 10' wird mit der Vorrichtung 100 zur Umwandlung von Licht in ein elektrisches Signal an einer Koppelstelle 500 verbunden. Die Koppelstelle kann beispielsweise eine Steckverbindung sein, mit der der Lichtwellenleiter 10' an das optische Übertragungselement 10 der Vorrichtung 100 angeschlossen ist. Der Lichtwellenleiter 10' kann auch durch eine Spleißverbindung 500 mit dem optischen Übertragungselement 10 der Vorrichtung 100 verbunden sein. Das optische Übertragungselement 10 der Vorrichtung 100 weist beispielsweise die in Figur 6 gezeigte Ausführung auf. Über die Koppelstelle wird Licht, das in dem inneren Bereich des Lichtwellenleiters 10' geführt wird, in den inneren Bereich des optischen Übertragungselements 10 eingekoppelt und weiterhin wird Licht, das in dem Lichtwellenleiter 10' in dem äußeren Bereich geführt ist, in den äußeren Bereich des optischen Übertragungselements 10 eingekoppelt.

Die Vorrichtung 100 kann eine der in den Figuren 1 bis 3A gezeigten Ausführungsformen des optischen Übertragungselements 10 beziehungsweise eine der in den Figuren 1 bis 3A gezeigten Ausführungsformen des fotoelektrischen Sensorelements 20 aufweisen. Beispielhaft ist die Vorrichtung 100 in der in Figur 2B dargestellten Ausführungsform ausgeführt. Das optische Übertragungselement 10 weist an einem Abschnitt BA mehrere Biegungen des Materials auf, die von einem fotoelektrischen Sensorelement 20 umgeben sind. Licht, das an der Koppelstelle 500 in den äußeren Bereich des optischen Übertragungselements 10 eingekoppelt worden ist, wird infolge der gebogenen Abschnitte des optischen Übertragungselement aus dem äußeren Bereich des optischen Übertragungselement ausgekoppelt und in das fotoelektrische Sensorelement 20 eingekoppelt. An Anschlüssen 40 des fotoelektrischen Sensorelements wird in Abhängigkeit von dem Pegel des eingekoppelten Lichts der Pegel eines elektrischen Signals, beispielsweise der Pegel einer Spannung, erzeugt. Die Anschlüsse 40 der Vorrichtung 10 können mit einer Empfangseinheit, beispielsweise einer Videokamera, verbunden sein. Zur Übertragung von Daten zur Empfangseinheit wird das in dem inneren Bereich 1 des optischen Übertragungselements 10 eingekoppelte Licht an einer Stirnfläche SF aus dem inneren Bereich des optischen Übertragungselements ausgekoppelt.

Wenn als Empfangseinheit eine Videokamera an die Vorrichtung 100 angeschlossen ist, kann das aus dem inneren Bereich des optischen Übertragungselements 10 ausgekoppelte Licht in eine Fotodiode der Videokamera eingekoppelt werden. Zur Rückübertragung einer Information kann das an der Stirnfläche SF ausgekoppelte Licht in der Empfangseinheit moduliert werden und wieder in das optische Übertragungselement 10 eingekoppelt werden. Zur Energieversorgung wird die Empfangseinheit mit den Anschlüssen 40 verbunden. Durch Lichtübertragung über den Lichtwellenleiter 10' wird an der Vorrichtung 100 somit eine Versorgungsspannung zum Betreiben einer Empfangseinheit bereitgestellt.

### Bezugszeichenliste

- 1: innerer Bereich eines optischen Übertragungselements
- 2: äußerer Bereich eines optischen Übertragungselements
- 3: Nanostrukturen
- 4: Ummantelung
- 10: optisches Übertragungselement
- 20: fotoelektrisches Sensorelement
- 21: Fotovoltaikfolie
- 22: fotoempfindliches Bauelement
- 23: Leiterplatte
- 24: optisches Sendebauelement
- 30: Trägerelement
- 40: Anschlüsse
- 50: Schutzkörper
- 60: Reflektor
- 70: Bauelemente zur Verarbeitung von Lichtsignalen
- 100: Vorrichtung zur Umwandlung von Licht in ein elektrisches Signal
- 200: Sendeeinheit zur Erzeugung von Licht zur Datenübertragung
- 300: Sendeeinheit zur Erzeugung von Licht zur Energieübertragung
- 400: Koppelement
- 500: Koppelstelle
- AL: ausgekoppeltes Licht
- L: Lagen
- BA: gebogener Abschnitt
- S: Seite
- SF: Stirnfläche

## Patentansprüche

1. Vorrichtung zur Umwandlung von Licht in ein elektrisches Signal, umfassend:
- ein optisches Übertragungselement (10) zur Übertragung von Licht,
- ein fotoelektrisches Sensorelement (20) zur Umwandlung von Licht in ein elektrisches Signal,
- wobei das optische Übertragungselement (10) derart ausgebildet ist, dass in dem optischen Übertragungselement (10) übertragenes Licht an dem gebogenen Abschnitt (BA) aus dem optischen Übertragungselement (10) ausgekoppelt wird,
- wobei das fotoelektrische Sensorelement (20) derart angeordnet ist, dass das aus dem optischen Übertragungselement (10) ausgekoppelte Licht in das fotoelektrische Sensorelement (20) eingekoppelt wird,
- wobei das fotoelektrische Sensorelement derart ausgebildet ist, dass das elektrische Signal beim Einkoppeln von Licht in das fotoelektrische Sensorelement (20) erzeugt wird, **dadurch gekennzeichnet, dass** das optische Übertragungselement (10) einen spiralförmig gebogenen Abschnitt (BA) aufweist und dass das optische Übertragungselement (10) von dem fotoelektrischen Sensorelement (20) umfänglich umgeben ist.

2. Vorrichtung nach Anspruch 1,
wobei mehrere Lagen (L1, L2) aus jeweils dem gebogenen Abschnitt (BA) des optischen Übertragungselements (10) und dem fotoelektrischen Sensorelement (20) übereinander angeordnet sind.

3. Vorrichtung nach einem der Ansprüche 1 oder 2,
- wobei das optische Übertragungselement (10) auf einem Trägerelement (30) angeordnet ist,
- wobei das Trägeelement (30) zylinderförmig oder kegelförmig ausgebildet ist.

4. Vorrichtung nach einem der Ansprüche 1 bis 3,
- wobei das optische Übertragungselement (10) in einem Schutzkörper (50) eingebettet angeordnet ist,
- wobei das Material des Schutzkörpers (50) transparent ausgebildet ist.

5. Vorrichtung nach einem der Ansprüche 1 bis 4,
wobei das optische Übertragungselement einen Lichtwellenleiter (10) umfasst.

6. Vorrichtung nach Anspruch 5,
wobei der Lichtwellenleiter (10) einen inneren Bereich (1) und einen äußeren Bereich (2) aufweist und zwischen dem inneren und äußeren Bereich eine Schicht von Nanostrukturen (3) angeordnet ist.

7. Vorrichtung nach Anspruch 5,
wobei der Lichtwellenleiter (10) einen inneren Bereich (1) und einen äußeren Bereich (2) aufweist und zwischen dem inneren und äußeren Bereich Hohlräume (3) angeordnet sind, die ein Gas enthalten.

8. Vorrichtung nach einem der Ansprüche 1 bis 7,
wobei das fotoelektrische Sensorelement (20) eine flexible Folie (21) mit einem lichtempfindlichen Material umfasst.

9. Vorrichtung nach einem der Ansprüche 5 bis 8,
wobei das fotoelektrische Sensorelement (20) als eine äußere Ummantelung (4) des Lichtwellenleiters (10) ausgebildet ist.

10. Verfahren zum Umwandlung von Licht in ein elektrisches Signal, umfassend:
- Bereitstellen eines optischen Übertragungselements (10) zur Übertragung von Licht und eines fotoelektrischen Sensorelements (20) zur Umwandlung von Licht in ein elektrisches Signal,
- Spiralförmiges Biegen eines Abschnitts (BA) des optischen Übertragungselements (10),
- Umfängliches Umgeben des optischen Übertragungselements (10) mit dem fotoelektrischen Sensorelement (20),
- Einkoppeln von Licht in das optische Übertragungselement (10),
- Auskoppeln des Lichts aus dem gebogenen Abschnitt (BA) des optischen Übertragungselements (10),
- Einkoppeln des Lichts in das fotoelektrische Sensorelement (20),
- Erzeugen des elektrischen Signals durch das fotoelektrische Sensorelement (20).

11. Verfahren nach Anspruch 10, umfassend:
Anordnen einer Lage (L2) aus weiteren gebogenen Abschnitten (BA') eines weiteren optischen Übertragungselements (10') und eines weiteren fotoelektrischen Sensorelements (20') um das fotoelektrische Sensorelement (20).

12. Verfahren nach einem der Ansprüche 10 oder 11, umfassend:
Einbetten des gebogenen Abschnitts (BA) des optischen Übertragungselements (10) in ein Material.

13. Verfahren nach einem der Ansprüche 10 bis 12, umfassend:
- Bereitstellen des optischen Übertragungselements (10) als ein Lichtwellenleiter,
- Anordnen des fotoelektrischen Sensorelements (20) als eine Ummantelung des Lichtwellenleiters.

14. Verfahren nach einem der Ansprüche 10 bis 13, umfassend:
- Bereitstellen des optischen Übertragungselements (10), das als ein Lichtwellenleiter ausgebildet ist, wobei der Lichtwellenleiter (10) einen inneren Bereich (1) und einen um den inneren Bereich angeordneten äußeren Bereich (2) aufweist,
- Einkoppeln von Licht zur Übertragung von Daten in den inneren Bereich (1) des Lichtwellenleiters (10),
- Einkoppeln von Licht zur Umwandlung in das elektrische Signal in den äußeren Bereich (2) des Lichtwellenleiters (10).

## Claims

1. A device for converting light into an electrical signal, comprising:
- an optical transmission element (10) for transmitting light,
- a photoelectric sensor element (20) for converting light into an electrical signal,
- wherein the optical transmission element (10) is formed in such a manner that light transmitted in the optical transmission element (10) is decoupled from the optical transmission element (10) at the bent portion,
- wherein the photoelectric sensor element (20) is arranged in such a manner that the light decoupled from the optical transmission element (10) is coupled into the photoelectric sensor element (20),
- wherein the photoelectric sensor element (20) is formed in such a manner that the electrical signal is produced during the process of coupling light into the photoelectric sensor element (20), **characterized in that** the optical transmission element (10) comprises a spirally bent portion (BA) and the optical transmission element (10) is circumferentially surrounded by the photoelectric sensor element (20).

2. The device according to claim 1,
wherein several layers (L1, L2) each made up of the bent portion (BA) of the optical transmission element (10) and the photoelectric sensor element (20) are arranged on top of each other.

3. The device according to any of the claims 1 or 2,
- wherein the optical transmission element (10) is arranged on a carrier element (30),
- wherein the carrier element (30) formed in the shape of a cylinder or cone.

4. The device according to any of the claims 1 to 3,
- wherein the optical transmission element (10) is arranged so as to be embedded in a protective body (50),
- wherein the material of the protective body (50) is formed to be transparent.

5. The device according to any of the claims 1 to 4,
- wherein the optical transmission element comprises a fiber optic cable (10).

6. The device according to claim 5,
- wherein the fiber optic cable (10) comprises an inner region (1) and an outer region (2) and a layer of nanostructures (3) is arranged between the inner and outer regions.

7. The device according to claim 5,
- wherein the fiber optic cable (10) comprises an inner region (1) and an outer region (2) and gas-containing cavities (3) are arranged between the inner and outer regions.

8. The device according to any of the claims 1 to 7,
- wherein the photoelectric sensor element (20) comprises a flexible film (21) including a light-sensitive material.

9. The device according to any of the claims 5 to 8,
wherein the photoelectric sensor element (20) is implemented as an outer sheathing (4) of the fiber optic cable (10).

10. A method of converting light into an electrical signal, comprising:
- providing an optical transmission element (10) for transmitting light and a photoelectric sensor element (20) for converting light into an electrical signal,
- spirally bending a portion (BA) of the optical transmission element (10),
- circumferentially surrounding the optical transmission element (10) with the photoelectric sensor element (20),
- coupling light into the optical transmission element (10),
- decoupling the light from the bent portion (BA) of the optical transmission element (10),
- coupling the light into the photoelectric sensor element (20),
- producing the electrical signal by the photoelectric sensor element (20).

11. The method according to claim 10, comprising:
arranging a layer (L2) of further bent portions (BA') of a further optical transmission element (10') and a further photoelectric sensor element (20') around the photoelectric sensor element (20).

12. The method according to any of the claims 10 or 11, comprising:
embedding the bent portion (BA) of the optical transmission element (10) in a material.

13. The method according to any of the claims 10 to 12, comprising:
- providing the optical transmission element (10) as a fiber optic cable (10),
- arranging the photoelectric sensor element (20) as a sheathing of the fiber optic cable.

14. The method according to any of the claims 10 to 13, comprising:
- providing the optical transmission element (10) which is formed as a fiber optic cable, said fiber optic cable (10) comprising an inner region (1) and an outer region (2) arranged around the inner region,
- coupling light, for transmitting data, into the inner region (1) of the fiber optic cable (10),
- coupling light, for conversion into the electrical signal, into the outer region (2) of the fiber optic cable (10).

## Revendications

1. Dispositif destiné à convertir de la lumière en un signal électrique, comprenant :
- un élément de transmission optique (10) destiné à transmettre de la lumière,
- un élément de détection photoélectrique (20) destiné à convertir de la lumière en un signal électrique,
- dans lequel l'élément de transmission optique (10) est constitué de telle manière que de la lumière transmise dans l'élément de transmission optique (10) soit découplée de l'élément de transmission optique (10) au niveau de la section (BA) courbe,
- dans lequel l'élément de détection photoélectrique (20) est disposé de telle manière que la lumière découplée de l'élément de transmission optique (10) soit couplée dans l'élément de détection photoélectrique (20),
- dans lequel l'élément de détection photoélectrique est constitué de telle manière que le signal électrique soit généré lors du couplage de lumière dans l'élément de détection photoélectrique (20), **caractérisé en ce que** l'élément de transmission optique (10) présente une section (BA) courbe en forme de spirale et **en ce que** l'élément de transmission optique (10) est entouré périphériquement par l'élément de détection photoélectrique (20).

2. Dispositif selon la revendication 1,
dans lequel plusieurs couches (L1, L2) constituées respectivement par la section (BA) courbe de l'élément de transmission optique (10) et par l'élément de détection photoélectrique (20) sont disposées les unes au-dessus des autres.

3. Dispositif selon l'une des revendications 1 ou 2,
- dans lequel l'élément de transmission optique (10) est disposé sur un élément support (30),
- l'élément support (30) étant constitué sous forme cylindrique ou sous forme conique.

4. Dispositif selon l'une des revendications 1 à 3,
- dans lequel l'élément de transmission optique (10) est disposé de manière encastrée dans un corps protecteur (50),
- dans lequel le matériau du corps protecteur (50) est constitué de manière transparente.

5. Dispositif selon l'une des revendications 1 à 4,
dans lequel l'élément de transmission optique comprend un conducteur à fibre optique (10).

6. Dispositif selon la revendication 5,
dans lequel le conducteur à fibre optique (10) présente une zone intérieure (1) et une zone extérieure (2) et une couche de nanostructures (3) est disposée entre la zone intérieure et la zone extérieure.

7. Dispositif selon la revendication 5,
dans lequel le conducteur à fibre optique (10) présente une zone intérieure (1) et une zone extérieure (2) et des cavités (3) contenant un gaz sont disposées entre la zone intérieure et la zone extérieure.

8. Dispositif selon l'une des revendications 1 à 7,
dans lequel l'élément de détection photoélectrique (20) comprend un film flexible (21) avec un matériau photosensible.

9. Dispositif selon l'une des revendications 5 à 8,
dans lequel l'élément de détection photoélectrique (20) est constitué comme enrobage extérieur (4) du conducteur à fibre optique (10).

10. Procédé destiné à convertir de la lumière en un signal électrique, comprenant :
- la mise à disposition d'un élément de transmission optique (10) destiné à transmettre de la lumière et d'un élément de détection photoélectrique (20) destiné à convertir de la lumière en un signal électrique,
- le cintrage en forme de spirale d'une section (BA) de l'élément de transmission optique (10),
- le fait d'entourer périphériquement l'élément de transmission optique (10) avec l'élément de détection photoélectrique (20),
- le couplage de lumière dans l'élément de transmission optique (10),
- le découplage de la lumière hors de la section (BA) courbe de l'élément de transmission optique (10),
- le couplage de la lumière dans l'élément de détection photoélectrique (20),
- la génération du signal électrique par l'élément de détection photoélectrique (20).

11. Procédé selon la revendication 10, comprenant :
la disposition d'une couche (L2) constituée par des sections (BA') courbes supplémentaires d'un élément de transmission optique (10') supplémentaire et d'un élément de détection photoélectrique (20') supplémentaire autour de l'élément de détection photoélectrique (20).

12. Procédé selon l'une des revendications 10 ou 11, comprenant :
l'encastrement de la section (BA) courbe de l'élément de transmission optique (10) dans un matériau.

13. Procédé selon l'une des revendications 10 à 12, comprenant :
- la mise à disposition de l'élément de transmission optique (10) sous forme de conducteur à fibre optique,
- la disposition de l'élément de détection photoélectrique (20) sous forme d'enrobage du conducteur à fibre optique.

14. Procédé selon l'une des revendications 10 à 13, comprenant :
- la mise à disposition de l'élément de transmission optique (10), qui est constitué sous forme de conducteur à fibre optique, le conducteur à fibre optique (10) présentant une zone intérieure (1) et une zone extérieure (2) disposée autour de la zone intérieure,
- le couplage de lumière, en vue de la transmission de données, dans la zone intérieure (1) du conducteur à fibre optique (10),
- le couplage de lumière, en vue de la conversion en le signal électrique, dans la zone extérieure (2) du conducteur à fibre optique (10).
